# EUROPEAN PATENT APPLICATION

(11) **EP 2 194 578 A1**
(43) Date of publication of application: **09.06.2010**
(21) Application number: 08170702.8
(22) Date of filing: 04.12.2008
(51) Int. Cl.: H01L 27/02

(54) **Bidirectional ESD power clamp**

(71) Applicant: IMEC, 3001 Leuven (BE)
(72) Inventor: Linten, Dimitri, 3190 Boortmeerbeek (BE); Thijs, Steven, 2830 Willebroek (BE); Tremouilles, David Eric, 12260 Villeneuve (FR); Natarajan, Mahadeva Iyer, 68600, Kottayam (IN)
(74) Representative: Sarlet, Steven Renaat Irène

(57) **Abstract**

The invention relates to a bidirectional ESD power clamp, comprising a semiconductor structure (BigNFET; BigPFET) having a conductive path connected between first and second nodes and having a triggering node via which the conductive path can be triggered. An ESD transient detection circuit is connected between the first and second nodes and to the triggering node and comprises a first part (10-17) for detecting occurrence of a first ESD transient on the first node. The semiconductor structure is provided on an insulator substrate, such that a parasitic conductive path between said first and second nodes via the substrate is avoided. The ESD transient detection circuit further comprises a second part (M1, M2) for detecting occurrence of a second ESD transient on the second node.

## Description

### Technical field

The present invention relates to an ESD power clamp according to the preamble of the first claim.

### Background art

In general RC-triggered power clamps are no bidirectional ESD devices on their own. Additional ESD devices need to be added in order to deliver bi-directional operation. Commonly a reverse diode will provide an additional current path. This additional diode requires additional silicon area for the ESD protection, which is undesirable.

### Disclosure of the invention

It is an aim of the present invention to provide a bidirectional ESD power clamp which consumes less area.

This aim is achieved according to the invention with an ESD power clamp showing the technical characteristics of the first claim.

The invention is a bidirectional ESD power clamp for protecting a circuit against an ESD transient occurring between a first node and a second node of the circuit. The power clamp comprises a semiconductor structure having a conductive path connected between the first and second nodes and having a triggering node via which the conductive path can be triggered from a non-conducting state to a conducting state, said semiconductor structure being adapted for conducting ESD currents via the conductive path in a first direction from the first node to the second node while in said conducting state. The power clamp further comprises an ESD transient detection circuit connected between the first and second nodes and to the triggering node and comprising a first part for detecting occurrence of a first ESD transient on said first node and for triggering said semiconductor structure via said triggering node upon such detection of a first ESD transient. The power clamp according to the invention is **characterised in that** said semiconductor structure is provided on an insulator substrate, such that a parasitic conductive path between said first and second nodes via said substrate is avoided. Further, the semiconductor structure is adapted for conducting ESD currents via the conductive path in a second direction from the second node to the first node while in said conducting state. Further, the ESD transient detection circuit further comprises a second part for detecting occurrence of a second ESD transient on the second node and for triggering the semiconductor structure via said triggering node upon such detection of a second ESD transient.

In the ESD power clamp according to the invention, the ESD current can be conducted through the same conductive path in both directions as a result of the characterising features described above. Hence, the need for an additional current path for the reverse direction can be avoided and the device area consumed can be reduced.

In preferred embodiments, the semiconductor structure is constructed in silicon on insulator (SOI) technology, i.e. compatible with SOI technology so that the power clamp and the protected circuit can be manufactured on the same wafer.

In preferred embodiments, the semiconductor structure is constructed in multigate (MugFET) technology, i.e. compatible with MugFET technology so that the power clamp and the protected circuit can be manufactured on the same wafer.

In preferred embodiments, the first part of the ESD transient detecting circuit comprises an RC-trigger. This RC-trigger is designed to trigger the power clamp on occurrence of the first ESD transient and to keep the power clamp in an off state during normal operation of the protected circuit.

In preferred embodiments, the second part of the ESD transient detecting circuit comprises at least one small transistor connected such to said first node, said second node and said triggering node that it passes on a voltage on said second node as a result of said second ESD transient to said triggering node. This at least one small transistor has the advantage that the voltage on the triggering node upon occurrence of the second ESD event can be better controlled. With "small" is meant here that the transistor is sized to conduct bias currents (e.g. on the order of milli-ampere), as opposed to for example a large transistor which is sized to conduct much higher ESD currents (e.g. on the order of ampere).

In preferred embodiments, said ESD transient detection circuit further comprises a latch for maintaining said semiconductor structure in said conductive state for a longer time period. This has the advantage that the semiconductor structure is kept open for a longer time period for conducting the ESD current, avoiding that the ESD current is interrupted too soon. Preferably, the latch comprises an inverter chain with feedback inverters.

In preferred embodiments, the power clamp further comprises a second small transistor having a gate connected to the second node and a channel bridging part of said latch. This second small transistor has the advantage that the voltage on the triggering node upon occurrence of the second ESD event can be better controlled.

### Brief description of the drawings

The invention will be further elucidated by means of the following description and the appended figures.
Figure 1 shows a prior art bidirectional ESD power clamp.
Figure 2 shows a schematic representation of a bidirectional ESD power clamp according to the invention.
Figure 3 shows a first preferred embodiment of a bidirectional ESD power clamp according to the invention.
Figure 4 shows the results of a simulation of the power clamp of figure 3: voltage on VDD pad during a 1 kV HBM ESD stress VDD to VSS.
Figure 5 shows the results of a simulation of the power clamp of figure 3: voltage on VDD pad and nodes a and e during 1 kV HBM ESD stress VSS to VDD.
Figure 6 shows a second preferred embodiment of a bidirectional ESD power clamp according to the invention.
Figure 7 shows the results of a simulation of the power clamp of figure 6: voltage on VDD pad and nodes d and e during 1 kV HBM ESD stress VSS to VDD.
Figure 8 shows a third preferred embodiment of a bidirectional ESD power clamp according to the invention.
Figure 9 shows the results of a simulation of the power clamp of figure 8: voltage on VDD pad and nodes d and e during 1 kV HBM ESD stress VSS to VDD.
Figure 10 shows the results of TLP measurements on the power clamp of figure 8 in both directions; failure current is around 1.8 A TLP, corresponding to - 2.5 kV HBM.
Figure 11 shows a fourth preferred embodiment of a bidirectional ESD power clamp according to the invention.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

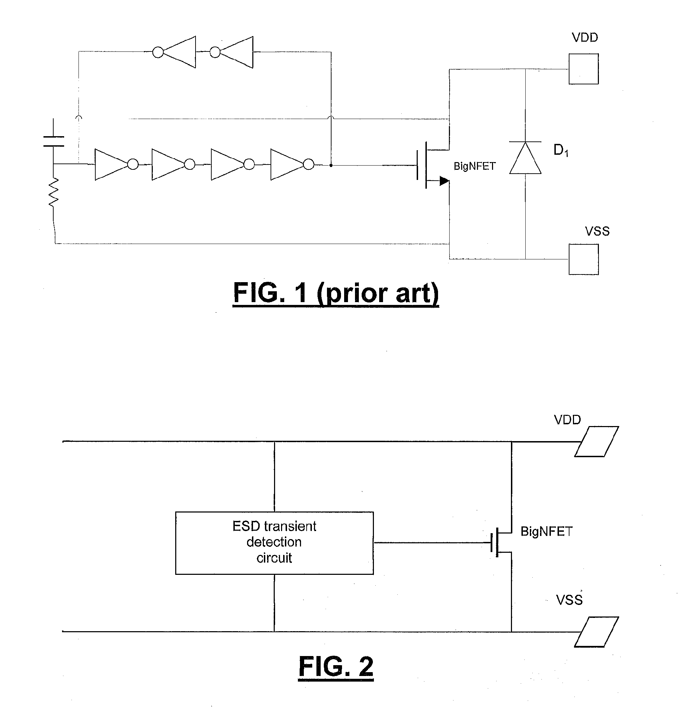

The operation of a prior art RC triggered clamp is explained by means of figure 1. In short, the capacitor, resistor and inverter chain form an ESD transient detection circuit. During a positive ESD stress between VDD and VSS, the voltage across the resistor and therefore across the gate of the BigFET goes high. A current path for the ESD current between VDD and VSS is formed through the BigFET, which is a very wide transistor. In general, prior art RC-triggered power clamps are no bidirectional ESD devices. Additional ESD devices need to be added in order to deliver bi-directional operation. Commonly a reverse diode like D1 in figure 1 will provide an additional current path. This additional diode requires additional silicon area for the ESD protection. The inverter chain, together with the feedback inverters, form a delay element in order to keep the voltage at the gate of the BigFet high as long as possible (- ms range). Both NMOS and PMOS type of transistors can be used as a bigFET.

According to the invention, embodiments of which are shown in figures 2, 3, 6 and 8, the need for a reverse diode D1 is avoided.

A first feature is that the BigFET is constructed as a semiconductor structure on an insulator substrate, such that a parasitic conductive path between the VDD and VSS nodes via the substrate is avoided. In other words, the BigFET has no bulk contact. An example of a suitable technology is Silicon On Insulator (SOI) CMOS technology, such as for example MuGFET or FinFET technology or the like.

A second feature is that the BigFET is constructed such that it is intrinsically a symmetric device, i.e. capable of conducting currents in both directions from VDD to VSS and vice versa.

A third feature is the addition of a component in the ESD transient detection circuit for triggering the BigFET in the reverse case, i.e. ESD event from VSS to VDD, making the clamp bidirectional via the same conductive path.

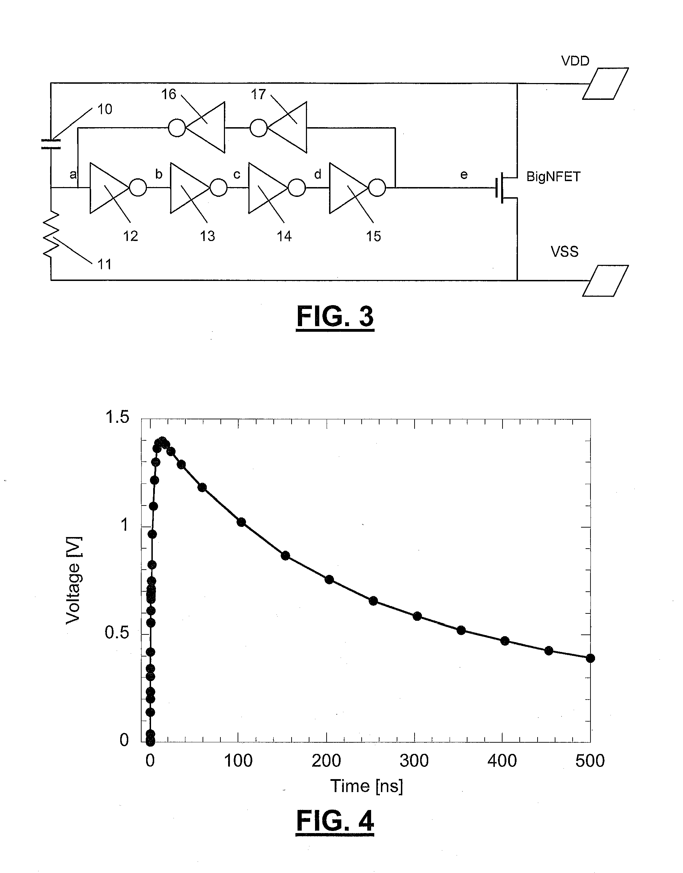

In the following, the operation of the specific embodiments of figures 3, 6 and 8 is described

Referring to figure 3, during positive ESD stress between VDD and VSS, VDD is pulled high in voltage with respect to VSS, the gate of the BigFET is pulled high, and a conducting path for the ESD current is formed between VDD and VSS through the BigFET. In particular, the transient signal on VDD is passed onto node a (high) by RC network. Inverters are functional and hence node b is inverted (low). Node c is high and d is low. Node e is high and BigNFET is pulled open to conduct ESD current in active mode. The feedback inverters relax constraints on the RC network to keep BigNFET open during full duration of ESD pulse. The voltage at node VDD during 1 kV HBM simulations is shown in figure 4.

During a negative ESD stress, VSS is pulled high with respect to VDD. The inverters are no longer inverting (in view of the reverse bias over their supply voltage and ground nodes (not shown)), but are acting as buffers: the output follows the input, but the signal is degraded. As VDD goes negative, this signal is coupled onto node a, and all other nodes (b-e) follow this signal. As a result, the gate-source voltage V_{GS} of the BigNFET is approximately zero, and hence the BigNFET is off.

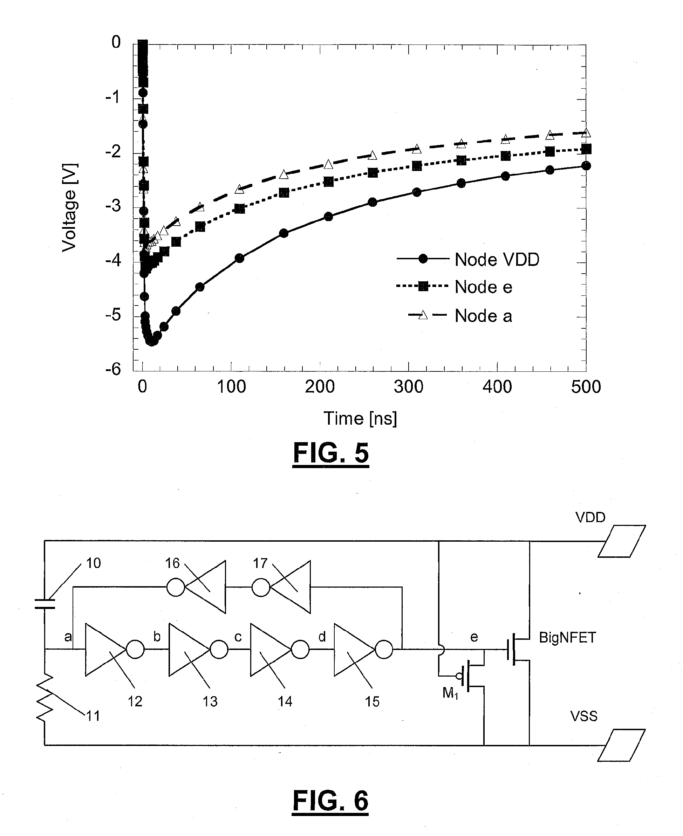

Simulations have shown that since node e does not follow node a exactly, at some moment the BigNFET will switch on, but at a too high voltage. See figure 5, which shows the voltage at nodes a, e and VDD during -1 kV HBM simulations. The voltage at which the BigNFET switches on is -5.5 V, which is too high.

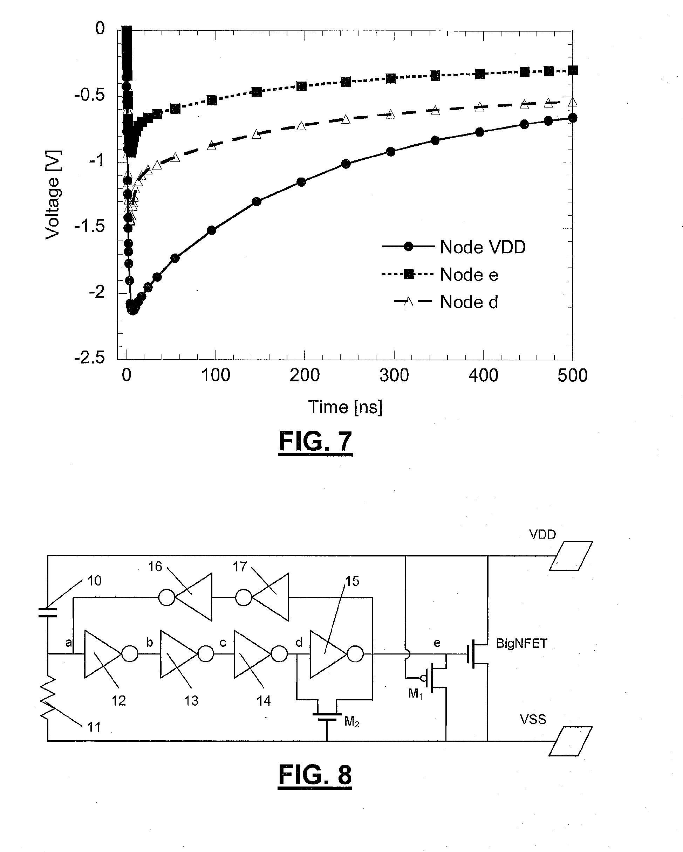

In order to avoid that node e goes negative and to open the BigNFET at a lower voltage during negative ESD stress, an additional small PMOS transistor M1 is preferably added to pull node e to GND during negative ESD stress, resulting in the embodiment of figure 6. Since node e is then controlled to be low during ESD, the BigNFET turns on at a much lower voltage. The maximum (absolute) voltage of node VDD is -2.1 V as shown in figure 7.

As can be seen from the figure 7, node e is not well controlled. This is because the PMOS transistor M1 is not in an inverter configuration. The output voltage at node e depends on the load of the PMOS. The load consists of the output of the inverter between nodes d and e. The voltage at node d is also shown in the figure 7. In this configuration, the PMOS of that inverter is in a conducting mode, limiting the pull-down of node e.

The solution can be further improved by controlling node d as well during negative ESD stress, trying to keep the output impedance of the inverter between nodes d and e as high as possible. Preferably, node d is pulled to approximately 0 V. To achieve this, additionally small NMOS transistor M2 is placed, resulting in the embodiment of figure 8.

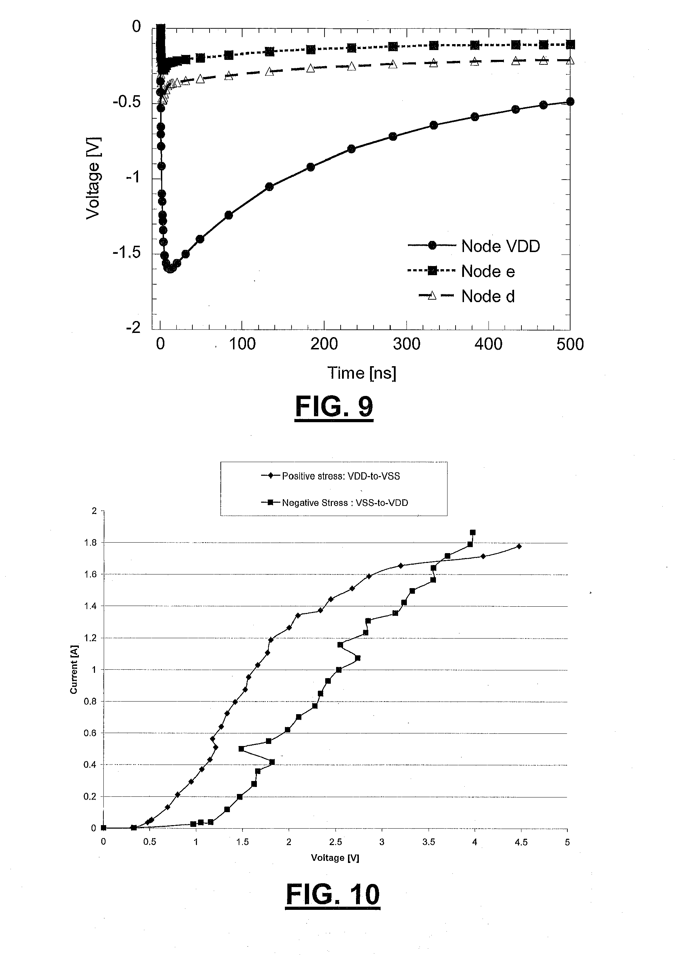

During negative ESD stress, M2 pulls node d as low as possible. This voltage is limited by the threshold voltage of the M2 and therefore, node d is not fully zero. As a result, the output impedance of the inverter between nodes d and e is not infinite, and hence node e cannot be pulled fully to zero as well. As shown in figure 9, the maximum (absolute) voltage at the VDD node is now limited to -1.6 V. This value is slightly higher than the maximum voltage during positive stress (1.4 V) due to the reasons explained above.

The same difference is seen in first measurement results, which are shown in figure 10 which shows the results of TLP measurements on the power clamp of figure 8 in both directions. The failure current is around 1.8 A TLP, corresponding to - 2.5 kV HBM.

Both additional transistors M1 and M2 do substantially not interfere with the operation during positive ESD stress. According to the invention, they form examples of the second part of the ESD transient detection circuit for detecting occurrence of a second (negative) ESD transient on the second node and for triggering the semiconductor structure BigNFET via its triggering node upon detection of the second ESD transient. M1 and M2 lead to substantially no additional device area in view of the fact that they are in the detection circuit part of the power clamp, so only need to conduct very small currents, for example on the order of milli-ampere. This is in strong contradiction with the diode D1 for the reverse ESD path of the prior art power clamp, which needs to conduct ESD current, for example on the order of ampere, and therefore requires a large device area.

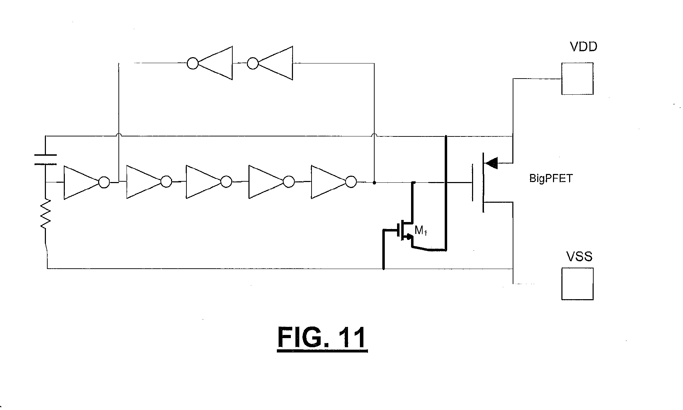

The embodiments of figures 3, 6 and 8 are bidirectional NMOS RC power clamps. The invention is also applicable for a bidirectional PMOS RC power clamps. An embodiment of such a circuit is shown in figure 11. It will be apparent to those skilled in the art that the operation principle is substantially the same as has been described above and therefore needs no further explanation here.

## Claims

1. Bidirectional ESD power clamp for protecting a circuit against an ESD transient occurring between a first node (VDD) and a second node (VSS) of the circuit, the power clamp comprising :
a semiconductor structure (BigNFET; BigPFET) having a conductive path connected between the first and second nodes and having a triggering node (e) via which the conductive path can be triggered from a non-conducting state to a conducting state, said semiconductor structure being adapted for conducting ESD currents via the conductive path in a first direction from the first node to the second node while in said conducting state;
an ESD transient detection circuit connected between the first and second nodes and to the triggering node and comprising a first part (10-17) for detecting occurrence of a first ESD transient on said first node and for triggering said semiconductor structure via said triggering node (e) upon such detection of a first ESD transient,
**characterised in that** said semiconductor structure (BigNFET; BigPFET) is provided on an insulator substrate, such that a parasitic conductive path between said first and second nodes via said substrate is avoided;
that said semiconductor structure is adapted for conducting ESD currents via the conductive path in a second direction from the second node to the first node while in said conducting state;
and that said ESD transient detection circuit further comprises a second part (M1, M2) for detecting occurrence of a second ESD transient on said second node and for triggering said semiconductor structure via said triggering node upon such detection of a second ESD transient.

2. Bidirectional ESD power clamp according to claim 1, **characterised in that** the semiconductor structure is constructed in silicon on insulator technology.

3. Bidirectional ESD power clamp according to claim 1, **characterised in that** the semiconductor structure is constructed in multigate technology.

4. Bidirectional ESD power clamp according to claim 1 or 2, **characterised in that** said first part comprises an RC-trigger (10-11).

5. Bidirectional ESD power clamp according to any one of the claims 1-3, **characterised in that** said second part comprises at least one small transistor (M1) connected to said first node, said second node and said triggering node in such a way that the transistor passes on a voltage on said second node as a result of said second ESD transient to said triggering node.

6. Bidirectional ESD power clamp according to claim 4, **characterised in that** said second part comprises a first small transistor (M1) having a gate connected to the first node and a channel connecting the second node to the triggering node.

7. Bidirectional ESD power clamp according to claim 5, **characterised in that** said semiconductor structure is a big NMOS field effect transistor and said first small transistor is a small PMOS transistor.

8. Bidirectional ESD power clamp according to claim 5, **characterised in that** said semiconductor structure is a big PMOS field effect transistor and said first small transistor is a small NMOS transistor.

9. Bidirectional ESD power claim according to any one of the previous claims, **characterised in that** said ESD transient detection circuit further comprises a latch (12-17) for maintaining said semiconductor structure in said conductive state for a longer time period.

10. Bidirectional ESD power clamp according to claim 8, **characterised in that** said latch comprises an inverter chain (12-15) with feedback inverters (16-17).

11. Bidirectional ESD power clamp according to claim 8 or 9, **characterised in that** said second part comprises a second small transistor (M2) having a gate connected to the second node and a channel bridging part of said latch.
